# EUROPEAN PATENT APPLICATION

(11) **EP 4 672 911 A2**
(43) Date of publication of application: **31.12.2025**
(21) Application number: 25175933.8
(22) Date of filing: 13.05.2025
(51) Int. Cl.: H10D 84/01, H10D 30/01, H10D 30/00, H10D 84/85, H10D 88/00

(54) **SEMICONDUCTOR DEVICE WITH SOURCE/DRAIN PATTERN HAVING DIFFERENT GERMANIUM CONCENTRATIONS**

(30) Priority: 25.06.2024 US 202463663930 P; 26.11.2024 US 202418960928
(71) Applicant: Samsung Electronics Co., Ltd., Suwon-si, Gyeonggi-do 16677 (KR)
(72) Inventor: CHO, Edward Namkyu, San Jose, CA, 95134 (US); SEO, Kang-ill, San Jose, CA, 95134 (US)
(74) Representative: Kuhnen & Wacker Patent- und Rechtsanwaltsbüro PartG mbB

(57) **Abstract**

Provided is a semiconductor device which includes: a channel structure; a source/drain pattern on the channel structure; a gate structure on the channel structure; and a contact layer on the channel structure, wherein the contact layer contacts the source/drain pattern and includes silicon germanium (SiGe), the source/drain pattern includes a 1^{st} portion and a 2^{nd} portion between the 1^{st} portion and the contact layer, the 1^{st} portion and the 2^{nd} portion have different germanium (Ge) concentrations, and a Ge concentraiotn in the contact layer is higher than a Ge concentration of the 1^{st} portion and lower than a Ge concentration of the 1^{st} portion.

## Description

### BACKGROUND

### 1. Field

Apparatuses and methods consistent with the disclosure relate to a semiconductor device in which a source/drain pattern is formed from a channel structure without inner spacers and has different germanium concentrations by portion.

### 2. Description of the Related Art

In a semiconductor device formed of one or more transistor structures, an inner spacer is formed between a gate structure and a source/drain pattern (or source/drain region) to isolate these two structural elements from each other and reduce parasitic capacitance generated therebetween. In a case where the transistor structures forming the semiconductor device are nanosheet transistors, also referred to as gate-all-around (GAA) transistors, or as a multi-bridge channel field-effect transistors (MBCFETs), the inner spacer is formed also to protect a source/drain pattern when sacrificial layers surrounding nanosheet channel layers are removed and replaced by a gate structure in a replacement gate structure (RMG) process of manufacturing the semiconductor device.

However, the inner spacer may affect an overall performance of a semiconductor device including the above-described transistors or any other type of transistor with respect to the formation of source/drain patterns.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

The disclosure provides a semiconductor device and a method of manufacturing the semiconductor device, in which a source/drain region is grown from a channel structure without inner spacers, and the source/drain region has a plurality of different germanium (Ge) concentrations by portion.

According to one or more embodiments, there is provided a semiconductor device which may include: a channel structure; a source/drain pattern on the channel structure; a gate structure on the channel structure; and a contact layer between the source/drain pattern and the channel structure, wherein the contact layer includes silicon germanium (SiGe) and is formed on a surface of the channel structure contacting the source/drain pattern.

According to one or more embodiments, there is provided a semiconductor device which may include: a channel structure; a source/drain pattern on the channel structure; and a gate structure on the channel structure, wherein an inner spacer including nitride is not disposed between the source/drain pattern and the gate structure.

According to one or more embodiments, there is provided a semiconductor device which may include: a channel structure; a source/drain pattern on the channel structure; a gate structure on the channel structure; and a contact layer on the channel structure, wherein the source/drain pattern includes a 1^{st} portion having a 1^{st} Ge concentration, and a 2^{nd} portion having a 2^{nd} Ge concentration lower thant the 1^{st} Ge concentration, and the contact layer has a 3^{rd} Ge concentration lower than the 1^{st} Ge concentration and higher than the 2^{nd} Ge concentration.

According to an embodiment, there is provided a method of manufacturing a semiconductor device. The method may include: forming a channel structure with a contact layer thereon, the contact layer including SiGe; forming a source/drain pattern based on the channel structure such that the source/drain pattern includes a 1^{st} portion having a 1^{st} germanium (Ge) concentration and a 2^{nd} portion having a 2^{nd} Ge concentration; and forming a gate structure on the channel structure, wherein the contact layer has a 3^{rd} Ge concentration lower than the 1^{st} Ge concentration and higher than the 2^{nd} Ge concentration.

### BRIEF DESCRIPTION OF DRAWINGS

Example embodiments of the disclosure will be more clearly understood from the following detailed description taken in conjunction with the accompanying drawings as follows.
FIG. 1 illustrates a semiconductor device including inner spacers between a source/drain pattern and a gate structure.
FIG. 2A illustrates a semiconductor device in which a source/drain pattern has a germanium (Ge) concentration varying by portion, without inner spacers at its side, according to one or more embodiments.
FIG. 2B illustrates a portion A shown in FIG. 2A in enlarged form, according to one or more embodiments.
FIG. 2C is a graph showing variation of Ge concentration across a channel layer and a source/drain pattern of a p-type transistor in the semiconductor device shown in FIG. 2B, according to one or more embodiments;
FIG. 3A illustrates a semiconductor device in which a source/drain pattern has a Ge concentration varying by portion, without inner spacers at its side, according to one or more other embodiments.
FIG. 3B illustrates a portion B shown in FIG. 3A in enlarged form, according to one or more embodiments.
FIG. 3C is a graph showing variation of Ge concentration across a channel layer and a source/drain pattern of an n-type transistor in the semiconductor device shown in FIG. 3B, according to one or more embodiments;
FIGS. 4A-4H illustrate intermediate semiconductor devices obtained after respective steps of forming a semiconductor device in which a source/drain pattern has a Ge concentration varying by portion, without inner spacers at its side, according to one or more embodiments.
FIG. 5 is a flowchart of manufacturing a semiconductor device shown in FIGS. 2A-2C, according to one or more embodiments.
FIG. 6 is a schematic block diagram illustrating an electronic device including at least one of the semiconductor devices of FIGS. 2A-2C and FIGS. 3A-3C, according to one or more embodiments.

### DETAILED DESCRIPTION

The embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof. For example, channel layers, sacrificial layers, and isolation layers described herein may take a different type or form as long as the disclosure can be applied thereto.

It will be understood that when an element, component, layer, pattern, structure, region, or so on (hereinafter collectively "element") of a semiconductor device is referred to as being "over," "above," "on," "below," "under," "beneath," "connected to" or "coupled to" another element the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, an element described as "below" or "beneath" another element would then be oriented "above" the other element. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions herebelow, the "left" element and the "right" element may also be referred to as a "1^{st}" element or a "2^{nd}" element, respectively, as long as their structural relationship is clearly understood in the context of the descriptions. Similarly, the terms a "lower" element and an "upper" element may be respectively referred to as a "1^{st}" element and a "2^{nd}" element with necessary descriptions to distinguish the two elements.

It will be understood that, although the terms "1^{st}," "2^{nd}," "3^{rd}," "4^{th}," "5^{th}," "6^{th}," etc. may be used herein to describe various elements, these elements should not be limited by these terms. These terms are only used to distinguish one element from another element. Thus, a 1^{st} element discussed below could be termed a 2^{nd} element without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" is used to compare a dimension of two or more elements, the term may cover a "substantially same" dimension.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to cross-sectional views that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. Various regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements, structures or layers of semiconductor devices including a nanosheet transistor and materials forming the same may or may not be described in detail herein. For example, a certain isolation layer or structure of a semiconductor device and materials forming the same may be omitted herein when this layer or structure is not related to the novel features of the embodiments. Also, descriptions of materials forming well-known structural elements of a semiconductor device may be omitted herein when those materials are not relevant to the novel features of the embodiments. Herein, the term "isolation" pertains to electrical insulation or separation between structures, layers, components or regions in a corresponding device or structure.

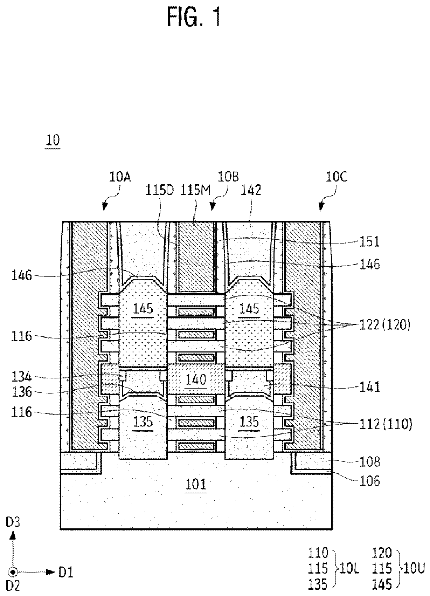

FIG. 1 illustrates a semiconductor device including inner spacers between a source/drain pattern and a gate structure.

Referring to FIG. 1, a semiconductor device 10 may be a three-dimension (3D) stacked semiconductor device which includes a 1^{st} semiconductor stack 10A, a 2^{nd} semiconductor stack 10B and a 3^{rd} semiconductor stack 10C on a substrate 101. The substrate 101 may be a silicon (Si) substrate, and additionally or alternatively, may include other materials such as silicon germanium (SiGe), silicon carbide (SiC), not being limited thereto.

Each of the semiconductor stacks 10A-10C may include a 1^{st} channel structure 110 surrounded by a gate structure 115 and a 2^{nd} channel structure 120 formed above the 1^{st} channel structure 110 and surrounded by the gate structure 115. The 1^{st} channel structure 110 may include a plurality of 1^{st} channel layers 112, and the 2^{nd} channel structure 120 may include a plurality of 2^{nd} channel layers 122. These channel layers may each be a thin nanosheet, nanowire or nanoribbon extended in a 1^{st} direction D1, and thus, a transistor including these channel layers may form a nanosheet transistor.

It is to be understood here that the 1^{st} direction D1 is a channel-length direction which is a direction of current flow between two source/drain patterns 135 (or 145) connected to each other through the channel structure 110 (or 120), and a 2^{nd} direction D2 horizontally intersecting the 1^{st} direction D1 is a channel-width direction. A 3^{rd} direction D3 vertically intersecting the 1^{st} direction D1 and the 2^{nd} direction D2 is a channel-thickness direction.

The channel layers 112 and 122 may each be formed of the same material, for example, silicon (Si) included in the substrate 101. Here, the 1^{st} and 2^{nd} channel structures 110 and 120 included in each of the 1^{st} and 3^{rd} semiconductor stacks 10A and 10C may be used to form source/drain patterns 135 and 145 as described later, but may not function as a channel of a transistor in some instances. Thus, the 1^{st} and 3^{rd} semiconductor stacks 10A and 10C may each be a dummy transistor structure, and may be removed in the semiconductor device 10 in its completed form. In other instances (not shown for simplicity), the 1^{st} and 3^{rd} semiconductor stacks 10A and 10C may be configured to be active regions of additional transistors, connecting even more source/drain patterns.

The 1^{st} source/drain patterns 135 and the 2^{nd} source/drain patterns 145 may be formed between the 1^{st} semiconductor stack 10A and the 2^{nd} semiconductor stack 10B, and between the 2^{nd} semiconductor stack 10B and the 3^{rd} semiconductor stack 10C. The 1^{st} source/drain patterns 135 may be connected to each other through the 1^{st} channel structure 110 surrounded by the gate structure 115 in the 2^{nd} semiconductor stack 10B, to form a 1^{st} transistor 10L (e.g., a "lower transistor"). The 2^{nd} source/drain patterns 145 may be connected to each other through the 2^{nd} channel structure 120 surrounded by the gate structure 115 in the 2^{nd} semiconductor stack 10B, to form a 2^{nd} transistor 10U (e.g., an "upper transistor") above the 1^{st} transistor 10L.

The 1^{st} source/drain patterns 135 may be formed of silicon (Si) doped with n-type impurities such as phosphorus (P), arsenic (As), antimony (Sb), etc. to form the 1^{st} transistor 10L as an n-type transistor. The 2^{nd} source/drain patterns 145 may be formed of silicon (Si) or silicon germanium (SiGe) doped with p-type impurities such as boron (B), gallium (Ga), indium (In), etc., to form the 2^{nd} transistor 10U as a p-type transistor. The disclosure is not limited thereto, however, and the 1^{st} transistor 10L may be formed as a p-type and the 2^{nd} transistor 10U may be formed as an n-type, or both of the 1^{st} and 2^{nd} transistors 10L and 10U may be formed as either a p-type or an n-type.

The gate structure 115 may include a gate dielectric layer 115D surrounding the channel structures 110 and 120 and a gate metal structure 115M on the gate dielectric layer 115D. The gate metal structure 115M may include a work-function metal layer and a gate electrode. The gate dielectric layer 115D may include an interfacial layer formed of an oxide material such as silicon oxide (SiO), silicon dioxide (SiO₂), and/or silicon oxynitride (SiON), and a high-k layer formed of a high-k material such as Hf, Al, Zr, La, Mg, Ba, Ti, Pb, and/or a combination thereof, not being limited thereto. The work-function metal layer of the gate metal structure 115M may be formed of a metal such as Cu, Al, Ti, Ta, W, Co, TiN, WN, TiAl, TiAlN, TaN, TiC, TaC, TiAlC, TaCN, TaSiN, and/or a combination thereof, not being limited thereto. The gate electrode of the gate metal structure 115M may be formed of Cu, W, Al, Ru, Mo, Co, and/or a combination thereof, not being limited thereof.

The work-function metal layer on the 1^{st} channel structure and the work-function metal layer on the 2^{nd} channel structure may be different from each other so that they may have different threshold voltages. For example, when the 1^{st} and 2^{nd} transistors 10L are 10U are of n-type and p-type, respectively, the 1^{st} gate structure 115 of the 1^{st} transistor 10L may include a work-function metal layer formed of Al or TiC, and the 2^{nd} gate structure 125 of the 2^{nd} transistor 10U may include a work-function metal layer formed of TiN, not being limited thereto.

In the semiconductor device 10, the gate structure 115 may be a common or shared gate structure of the 1^{st} transistor 10L and the 2^{nd} transistor 10U to form the semiconductor device 10 as a complementary metal-oxide-semiconductor (CMOS) device such as an inverter circuit. However, according to one or more other embodiments, the gate structure 115 may be divided into two different gate structures isolated from each other and respectively surrounding the 1^{st} channel structure 110 and the 2^{nd} channel structure 120 to form the semiconductor device 10 as a different type of 3D-stacked semiconductor device.

A shallow trench isolation (STI) structure 108 that isolates the semiconductor device 10 from one or more adjacent semiconductor devices or other circuit elements may be formed at upper-left and upper-right corners of the substrate 101 with an STI liner 106 therebetween to protect the substrate from the STI structure 108. The STI structure 108 may include silicon oxide (e.g., SiO or SiO₂), not being limited thereto, and the STI liner 106 may include silicon nitride (e.g., SiN or Si₃N₄), not being limited thereto.

A 1^{st} isolation structure 141 between the 1^{st} source/drain pattern 135 and the 2^{nd} source/drain pattern 145, and a 2^{nd} isolation structure 142 above the 2^{nd} source/drain patterns 145 may be formed to isolate the source/drain patterns 135 and 145 from each other or from other circuit elements. The isolation structures 141 and 142 may both be formed of silicon oxide (e.g., SiO or SiO₂), not being limited thereto. Further, a 1^{st} protection layer 136 may be formed on the 1^{st} source/drain patterns 135 at least to prevent oxidation thereof from the 1^{st} isolation structure 141, and a 2^{nd} protection layer 146 may be formed on the 2^{nd} source/drain patterns 145 at least to prevent oxidation thereof from the 2^{nd} isolation structure 142. The protection layers 136 and 146 may each be formed of silicon nitride or a composite thereof (e.g., SiN, Si₃N₄, SiBCN, SiCN, SiOCN, etc.), not being limited thereto.

A middle isolation structure 140 may be formed between a portion of the gate structure 115 surrounding the 1^{st} channel structure 110 and another portion of the gate structure 115 surrounding the 2^{nd} channel structure 120. The middle isolation structure 140 may be formed of a dielectric material such as silicon nitride or a composite thereof (e.g., SiBCN, SiCN, SiOCN, SiN, etc.), not being limited thereto. Between the middle isolation structure 140 and the 1^{st} isolation structure 141 may be formed a blocking layer 134 used to cover the 2^{nd} channel structure 120 when the 1^{st} source/drain patterns 135 are formed in the process of manufacturing the semiconductor device 10. The blocking layer 134 may include a material such as a silicon nitride (e.g., SiN, Si₃N₄, etc.), not being limited thereto.

The semiconductor device 10 may also include inner spacers 116 formed between the gate structure 115 and each of the source/drain patterns 135 and 145, and gate spacers 151 formed on side surfaces of the gate structure 115 in each of the semiconductor stacks 10A-10C to prevent the gate structure 115 from being oxidized in a process of manufacturing the semiconductor device 10. The gate spacers 151 may also isolate the gate structure 115 from other circuit elements.

The inner spacers 116 may be formed of silicon nitride, silicon oxide or a composite thereof (e.g., SiN, SiO₂, SiBCN, SiCN, SiON, SiOCN, etc.), not being limited thereto. The gate spacers 151 may be formed of silicon nitride, silicon oxide or a composite thereof (e.g., SiN, SiO₂, SiBCN, SiCN, SiON, SiOCN, etc.), not being limited thereto, which may be different from the material(s) forming the inner spacers 116 at least in terms of etch selectivity.

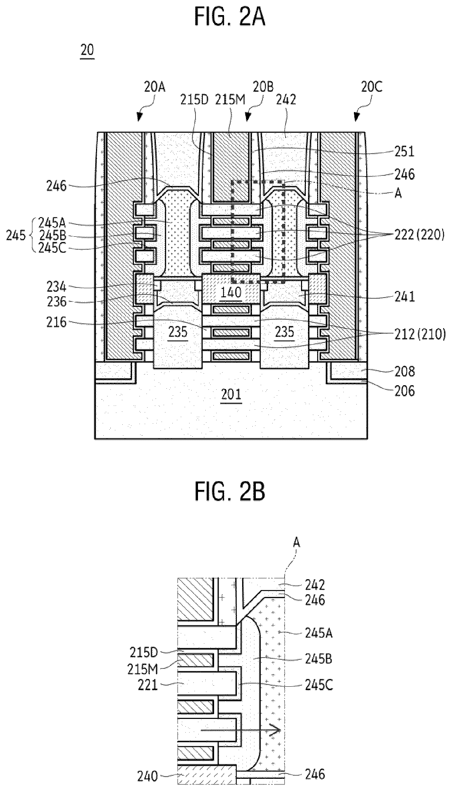

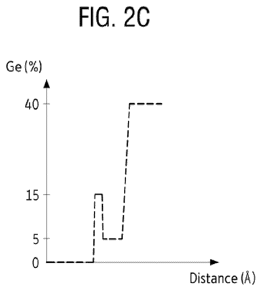

In the meantime, the 2^{nd} source/drain patterns 145 respectively connected to the 2^{nd} channel layers 122 may be formed by epitaxial growth from a crystal structure of silicon (Si) included in the 2^{nd} channel layers 122. However, when the 2^{nd} source/drain patterns 145 are epitaxially grown from the 2^{nd} channel layers 122, an amorphous structure of silicon nitride, silicon oxide or a composite thereof included in the inner spacers 116 may cause a crystal defect such as crack formation in the 2^{nd} source/drain patterns 145. Then, the 2^{nd} source/drain patterns 145 formed of silicon germanium (SiGe) may not exert a sufficient compressive stress to the 2^{nd} channel layers 122 required to enhance hole mobility therethrough between the 2^{nd} source/drain patterns 145, thereby failing to obtain a desired device performance for the semiconductor device 10. Thus, in order to address this aspect of the 2^{nd} source/drain patterns 145, the following embodiments are provided in reference to FIG. 2.

FIG. 2A illustrates a semiconductor device in which a source/drain pattern has a germanium (Ge) concentration varying by portion, without inner spacers at its side, according to one or more embodiments. FIG. 2B illustrates a portion A shown in FIG. 2A in enlarged form, according to one or more embodiments. FIG. 2C is a graph showing variation of Ge concentration across a channel layer and a source/drain pattern of a p-type transistor in the semiconductor device shown in FIG. 2B, according to one or more embodiments.

Referring to FIG. 2A, a semiconductor device 20 may include 1^{st} to 3^{rd} semiconductor stacks 20A-20C which have a similar structural shape as the semiconductor stacks 10A-10C of the semiconductor device 10 of FIG. 1. Thus, duplicate descriptions thereof may be omitted, and instead, different aspects of the semiconductor device 20 may be described herebelow.

For example, the semiconductor device 20 may include a 1^{st} transistor 20L which is the same as the 1^{st} transistor 10L of the semiconductor device 10. Thus, a substrate 201, a 1^{st} channel structure 210 including 1^{st} channel layers 212, 1^{st} source/drain patterns 235, a 1^{st} protection layer 236, a gate structure 215 including a gate dielectric layer 215D and a gate metal structure 215M, a gate spacer 251, an STI structure 208, an STI liner 206, a middle isolation structure 240, a blocking layer 234, a 1^{st} isolation structure 241, and inner spacers 216 between the gate structure and the 1^{st} source/drain patterns 235 may be the same as or similar to corresponding structural elements of the semiconductor device 10 shown in FIG. 1. Further, a 2^{nd} protection layer 246 and a 2^{nd} isolation structure 242 of the semiconductor device 20 may also be the same as or similar to corresponding structural elements of the semiconductor device 10.

However, a 2^{nd} transistor 20U of the semiconductor device 20 may differ from the 2^{nd} transistor 10U of the semiconductor device 10 at least in that 2^{nd} source/drain patterns 245 connected to a 2^{nd} channel structure 220 (2^{nd} channel layers 222) have a structure which his different from the 2^{nd} source/drain patterns 145 of the semiconductor device 10. For example, each of the 2^{nd} source/drain patterns 245 formed of silicon germanium (SiGe) may have an inner portion 245A and outer portions 245B at both sides of the inner portion 245A close to or contacting the 2^{nd} channel structures 220 (2^{nd} channel layers 222). The inner portion 245A and the outer portions 245B may have respectively different germanium (Ge) concentrations. For example, the inner portion 245A may have a higher Ge concentration than the outer portions 245B. For example, the Ge concentration of the inner portion 245A may range between 40% and 50%, and the Ge concentration of the outer portions 245B may be about 10% or less, e.g., 5%. It is to be understood here that, for example, the Ge concentration 5% of a certain SiGe layer means that 5% of the entire material forming the SiGe layer is Ge.

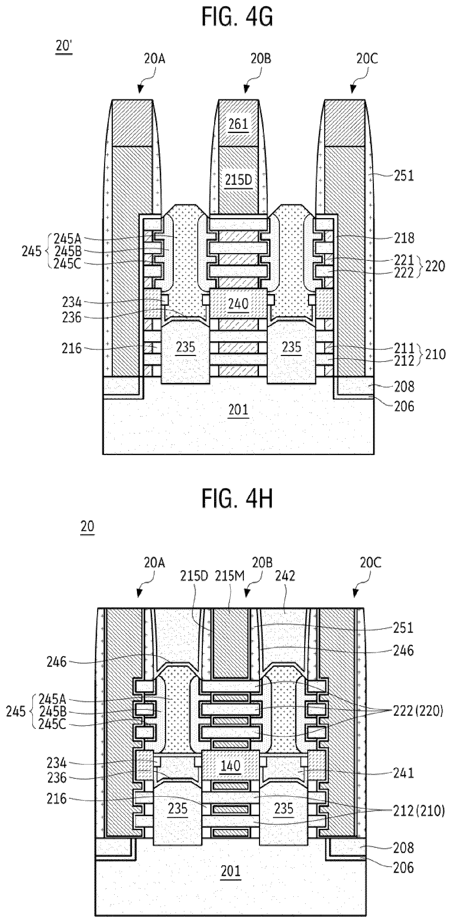

As will be described later in reference to FIG. 4G, the inner portion 245A and the outer portions 245B of each of the 2^{nd} source/drain patterns 245 may be formed to have different, discontinuous or discrete Ge concentrations by controlling a mixing ratio of an Si gas and a Ge gas during epitaxial growth of the 2^{nd} source/drain pattern 245 from the 2^{nd} channel layers 222 through, for example, molecular beam epitaxy (MBE), vapor-phase epitaxy (VPE), etc., not being limited thereto.

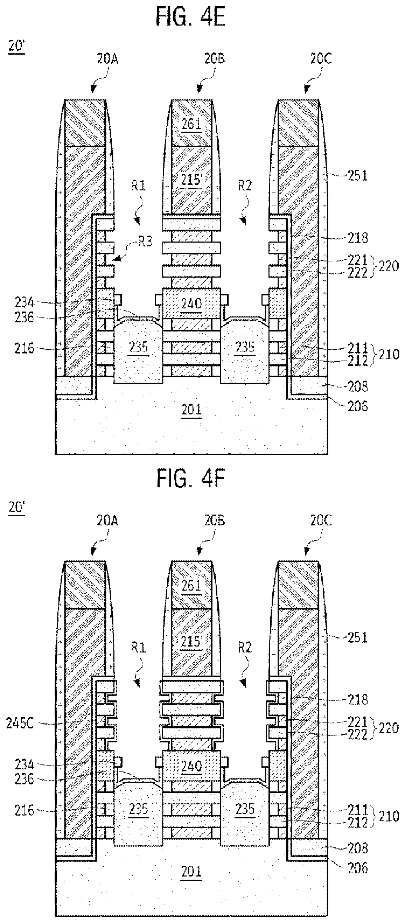

Moreover, a contact layer 245C of SiGe may be formed between the outer portion 245B and each of the 2^{nd} channel layers 222. The contact layer 245C may be formed on a surface of the 2^{nd} channel layer 222 contacting the outer portion 245B of the 2^{nd} source/drain pattern 245, and thus, may be considered an edge portion of the 2^{nd} source/drain pattern 245 or an edge portion of the 2^{nd} channel layer 222. The contact layer 245C may have a Ge concentration higher than the outer portion 245B and lower than the inner portion 245A. For example, the contact layer 245C may have a Ge concentration of 20% or less, e.g., 15%. As will be described later in reference to FIG. 4F, the contact layer 245C of SiGe may have been formed on the surfaces of the 2^{nd} channel layers 222 in a hydrogen (H₂) baking process of manufacturing the semiconductor device 20, in which SiGe forming 2^{nd} sacrificial layers 221 stacked on the 2^{nd} channel layers 222 are diffused on to a portion of each of the 2^{nd} channel layers 222.

According to the above difference of Ge concentration between the inner portion 245A and the outer portions 245B of the 2^{nd} source/drain pattern 245 and the contact layer 245C in the semiconductor device 20, a line scan by Energy Dispersive X-ray Spectroscopy (EDX) from a center of the 2^{nd} channel layer 222 to a center of the 2^{nd} source/drain pattern 245 in the 1^{st} direction D1 (as indicated by an arrow in FIG. 2B) shows in FIG. 2C that Ge concentration sharply increases from almost 0% in the 2^{nd} channel layer 222 to approximately 15% in the contact layer 245C, decreases to approximately 5% in the outer portion 245B, and then sharply increases to approximately 40% or higher in the inner potion 245A.

In the meantime, the inner spacers 216 formed between the gate structure 215 and each of the 1^{st} source/drain patterns 235 for the 1^{st} transistor 20L may not be formed between the gate structure 215 and each of the 2^{nd} source/drain patterns 245 for the 2^{nd} transistor 20U. Thus, the 2^{nd} source/drain patterns 245 may have been epitaxially grown only from crystal structures of silicon (Si) of the 2^{nd} channel layers 222, silicon germanium (SiGe) of the contact layers 245C and SiGe of the 2^{nd} sacrificial layers 221, which will be described later in reference to FIG. 4G. Thus, compared to the 2^{nd} source/drain patterns 145 of the semiconductor device 10 of which the epitaxial growth is affected by the inner spacers 116 as described above in reference to FIG. 1, the 2^{nd} source/drain patterns 245 may have been epitaxially grown without being affected by inner spacers so that a crystal defect such as crack formation may not have occurred in the 2^{nd} source/drain patterns 245. Accordingly, the 2^{nd} source/drain patterns 245 of SiGe may be able to exert a sufficient compressive stress to the 2^{nd} channel layers 222 to enhance hole mobility therethrough between the 2^{nd} source/drain patterns 245, thereby enhancing device performance of the semiconductor device 20. Further, as the semiconductor device 20 may dispense with inner spacers between the gate structure 215 and the 2^{nd} source/drain pattern 245, a contact area between the 2^{nd} channel layer 222 and the 2^{nd} source/drain pattern 245 may increase, which may also improve the device performance.

In the above embodiments of FIGS. 2A-2C, the 2^{nd} source/drain patterns 245 of p-type including SiGe may be formed without the inner spacers 216 at an upper stack of the semiconductor device 20 which is a 3D-stacked semiconductor device. However, the disclosure is not limited thereto. According to one or more other embodiments, the same 2^{nd} source/drain patterns 245 of p-type including SiGe may be formed at a lower stack, and instead the 1^{st} source/drain patterns 235 of n-type including Si may be formed at an upper stack to form a 3D-stacked semiconductor device so that a p-type transistor is formed at a lower stack and an n-type transistor is formed at an upper stack.

Further, the above embodiments of a source/drain pattern of p-type including SiGe with varying Ge concentration without inner spacers at a side thereof may be formed for a single-stack semiconductor device, according to one or more other embodiments.

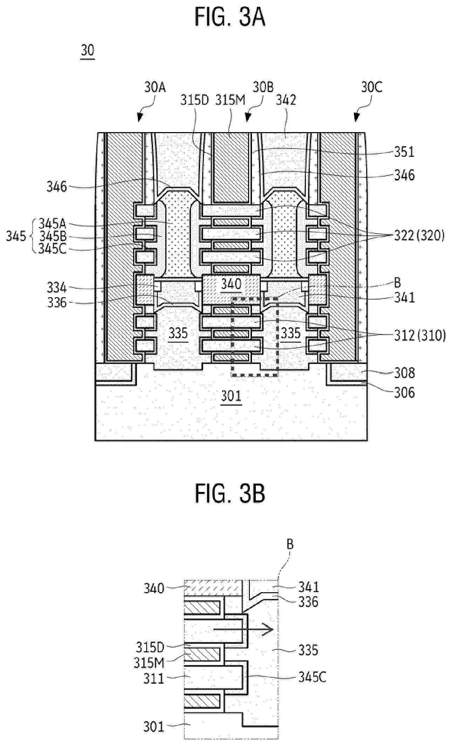

Moreover, in the above embodiments of FIGS. 2A-2C, only the 2^{nd} source/drain patterns 245 of p-type including SiGe may be formed without the inner spacers 216 while the 1^{st} source/drain patterns 235 of n-type including Si may be formed with the inner spacers 216. However, the disclosure is not limited thereto. According to one or more other embodiments, the 1^{st} source/drain patterns 235 may also be formed without the inner spacers 216 as shown in FIGS. 3A-3C.

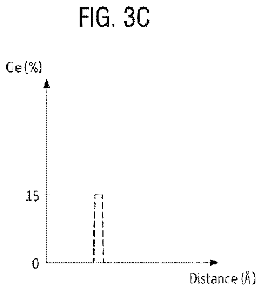

FIG. 3A illustrates a semiconductor device in which a source/drain pattern has a Ge concentration varying by portion, without inner spacers at its side, according to one or more other embodiments. FIG. 3B illustrates a portion B shown in FIG. 3A in enlarged form, according to one or more embodiments. FIG. 3C is a graph showing variation of Ge concentration across a channel layer and a source/drain pattern of an n-type transistor in the semiconductor device shown in FIG. 3B, according to one or more embodiments.

Referring to FIG. 3A, a semiconductor device 30 may include 1^{st} to 3^{rd} semiconductor stacks 30A-30C which have a similar structural shape as the semiconductor stacks 20A-20C of the semiconductor device 20 of FIG. 2. Thus, duplicate descriptions thereof may be omitted, and instead, different aspects of the semiconductor device 30 may be described herebelow.

For example, the semiconductor device 30 may include a 2^{nd} transistor 30U which is the same as the 2^{nd} transistor 20U of the semiconductor device. Thus, a substrate 301, a 2^{nd} channel structure 320 including 2^{nd} channel layers 322, 2^{nd} source/drain patterns 345 including an inner portion 345A and outer portions 345B, a contact layer 345C, a 2^{nd} protection layer 346, a gate structure 315 including a gate dielectric layer 315D and a gate metal structure 315M, a gate spacer 351, an STI structure 308, an STI liner 306, a middle isolation structure 340, a blocking layer 334, and a 2^{nd} isolation structure 342 may be the same as or similar to corresponding structural elements of the semiconductor device 20 shown in FIG. 2. Further, a 1^{st} protection layer 336 and a 1^{st} isolation structure 341 of the semiconductor device 30 may be the same as or similar to corresponding structural elements of the semiconductor device 20.

Compared to the semiconductor device 20, the semiconductor device 30 may be characterized in that not only the 2^{nd} source/drain patterns 345 but also 1^{st} source/drain patterns 335 therebelow may have been epitaxially grown without being affected by inner spacers because no inner spacers may be formed between the gate structure 315 and each of the 1^{st} source/drain patterns 335 in the 1^{st} transistor 30L as in the 2^{nd} transistor 30U.

Further, the contact layer 345C formed on the 2^{nd} channel layers of the 2^{nd} channel structure 320 may also be formed on surfaces of 1^{st} channel layers 312 of a 1^{st} channel structure 310 contacting 1^{st} source/drain patterns 335. Thus, the contact layer 345C may also be disposed between each of the 1^{st} source/drain patterns 335 and each of the 1^{st} channel layers 312. Thus, the contact layer 345C formed on the surfaces of the 1^{st} channel layers 312 may be considered an edge portion of the 1^{st} source/drain pattern 335 or an edge portion of the 1^{st} channel layer 312. As in the semiconductor device 20, the contact layer 345C may have a Ge concentration of 20% or less, e.g., 15%. The contact layer 345C may have been formed on the surfaces of the channel layers 312 and 322 in a hydrogen baking process of manufacturing the semiconductor device 30 when SiGe forming sacrificial layers stacked on the channel layers 312 and 322 are diffused on to a portion of each of the channel layers 312 and 322.

Accordingly, a line scan by the EDX from a center of the 1^{st} channel layer 312 to a center of the 1^{st} source/drain pattern 335 in the 1^{st} direction D1 (as indicated by an arrow in FIG. 3B) shows in FIG. 3C that Ge concentration sharply increases from almost 0% in the 1^{st} channel layer 312 to approximately 15% in the contact layer 345C and sharply decreases to almost 0% in the 1^{st} source/drain pattern 335.

Due to the above structural characteristics, the 1^{st} source/drain patterns 335 may have been epitaxially grown only from crystal structures of Si of the 1^{st} channel layers 312, SiGe of the contact layer 345C, and SiGe of the sacrificial layers to be replaced by the gate structure 315 in a later step of manufacturing the semiconductor device 30. Therefore, in the semiconductor device 30, the 1^{st} source/drain patterns 335 as well as the 2^{nd} source/drain patterns 345 may have been epitaxially grown without a crystal defect such as crack formation therein. Accordingly, while the 2^{nd} source/drain patterns 345 of SiGe may be able to exert a sufficient compressive stress to the 2^{nd} channel layers 322 to enhance hole mobility therethrough between the 2^{nd} source/drain patterns 345, the 1^{st} source/drain patterns 335 of Si may be able to exert a sufficient tensile stress to the 1^{st} channel layers 312 to enhance electron mobility therethrough between the 1^{st} source/drain patterns 335, thereby enhancing device performance of the semiconductor device 30.

In the above embodiments, formation of a source/drain pattern without being affected by inner spacers or without forming inner spacers is described with respect to a 3D-stacked semiconductor device. However, the disclosure is not limited thereto. According to one or more other embodiments, a source/drain pattern of a single-stack semiconductor device may also be formed without being affected by inner spacers or without forming inner spacers.

In the meantime, the semiconductor devices 20 and 30 described above in reference to FIGS. 2A and 3A have two 1^{st} channel layers at the lower stack and thee 2^{nd} channel layers at the upper stack. However, the disclosure is not limited thereto. According to one or more other embodiments, the number of channel layers at the lower stack and the upper stack may be the same.

Herebelow, a method of manufacturing a semiconductor device in which a source/drain pattern has a Ge concentration varying by portion, without inner spacers at its side, is provided, according to one or more embodiments.

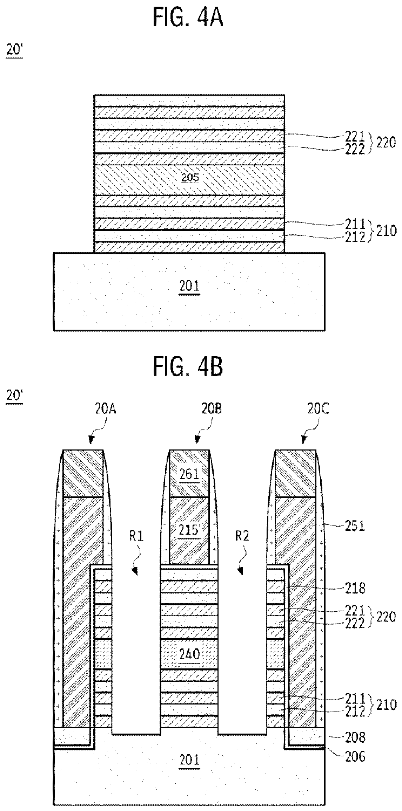

FIGS. 4A-4H illustrate intermediate semiconductor devices obtained after respective steps of forming a semiconductor device in which a source/drain pattern has a Ge concentration varying by portion, without inner spacers at its side, according to one or more embodiments.

As the semiconductor device manufactured through the respective steps as shown in FIGS. 4A-4H may be the same as or may correspond to the semiconductor device 20 shown in FIGS. 2A-2C, duplicate descriptions thereof may be omitted and the same reference numbers may be used in the descriptions herebelow.

Referring to FIG. 4A, an initial semiconductor stack 20' may be formed by epitaxially growing a plurality of semiconductor layers on a substrate 201 in the order of a 1^{st} channel structure 210, a middle sacrificial layer 205, and a 2^{nd} channel structure 220.

The 1^{st} channel structure 210 may include 1^{st} sacrificial layers 211 and 1^{st} channel layers 212 vertically stacked in an alternating manner on the substrate 201. A 1^{st} channel layer 212 may be interposed between two adjacent 1^{st} sacrificial layers 211. On the 1^{st} channel structure 210 may be formed the middle sacrificial layer 205, and the 2^{nd} channel structure 220 may be formed on the middle sacrificial layer 205. The 2^{nd} channel structure 220 may include 2^{nd} sacrificial layers 221 and 2^{nd} channel layers 222 vertically stacked in an alternating manner on the middle sacrificial layer 205. A 2^{nd} channel layer 222 may be interposed between two adjacent 2^{nd} sacrificial layer 221.

While the substrate 201 and the channel layers 212 and 222 are formed of silicon (Si), the sacrificial layers 211, 205 and 221 may be formed of silicon germanium (SiGe) with respective Ge concentrations therein. The middle sacrificial layer 205 may have a higher Ge concentration than the 1^{st} and 2^{nd} sacrificial layers 211 and 221. For example, the middle sacrificial layer 205 may have a Ge concentration of 40-45%, and the 1^{st} and 2^{nd} sacrificial layers 211 and 221 may have a Ge concentration of 25-30%.

Here, the sacrificial layers 211, 205 and 221 are referred to as such because these layers will be removed and replaced by other layers or structures in later steps of manufacturing a semiconductor device from the initial semiconductor stack 20'.

Referring to FIG. 4B, the substrate 201 may be patterned to form a shallow trench isolation (STI) structure 208 that will isolate a semiconductor device formed on the substrate 201 from an adjacent device or circuit element. An STI liner 206 may be formed before the STI structure 108 is formed on the substrate 201.

A barrier layer 218 may be formed to surround the initial semiconductor stack 20' of FIG. 4A to protect at least the channel layers 212 and 222 in subsequent processes of manufacturing a semiconductor device, and then, an initial dummy gate structure with hard mask patterns 261 thereon may be formed on the initial semiconductor stack 20' with the barrier layer 218 therebetween. Next, the initial dummy gate structure and the barrier layer 218 may be patterned through, for example, directional dry etching such as reactive ion etching (RIE), based on the hard mask patterns 261 to obtain three dummy gate structures 215' on the initial semiconductor stack 20', and gate spacers 251 may be formed on side surfaces of the dummy gate structures 250D.

Further, the initial semiconductor stack 20' may be patterned through, for example, drying etching (e.g., RIE), to form 1^{st} to 3^{rd} semiconductor stacks 20A, 20B and 20C based on the hard mask patterns 261 and the gate spacers 251 as a masking structure. The dummy gate structures 215' may include a material such as amorphous silicon (a-Si) or polysilicon (p-Si), not being limited thereto. The barrier layer 218 may be formed of silicon oxide (e.g., SiO or SiO₂), not being limited thereto. The hard mask patterns 161 may include a dielectric material such as silicon nitride (SiN), titanium nitride (TiN), or silicon oxynitride (SiON), not being limited thereto.

The patterning of the initial semiconductor stack 20' may be performed such that two recesses R1 and R2 are formed to divide the initial semiconductor stack 20' into the semiconductor stacks 20A-20C, and each of the recesses R1 and R2 exposes a top surface of the substrate 201 and side surfaces of the 1^{st} channel structure 210, a middle isolation structure 240, and the 2^{nd} channel structure 220 in their divided form. Here, the middle isolation structure 240 may be a replacement structure formed of silicon nitride or a composite thereof such as SiBCN, not being limited thereto. As the Ge concentration of the middle sacrificial layer 205 is higher than the 1^{st} and 2^{nd} sacrificial layers 211 and 221 as described earlier in references to FIG. 4A, the middle sacrificial layer 205 may have been removed through, for example, selective wet etching against the 1^{st} and 2^{nd} sacrificial layers 211 and 221, followed by formation of the middle isolation structure 240 in a space provided by the removal of the middle sacrificial layer 205.

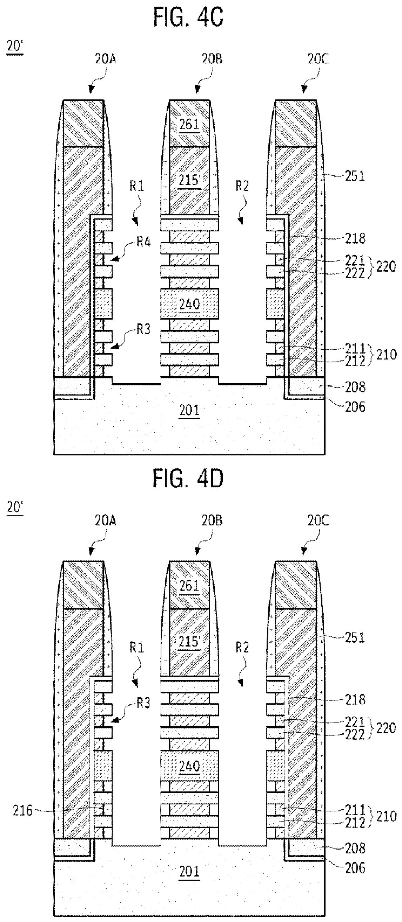

Referring to FIG. 4C, a selective etching operation may be performed on the side surfaces of the 1^{st} channel structure 210, the middle isolation structure 240, and the 2^{nd} channel structure 220 of each of the semiconductor stacks 20A-20C exposed though the recesses R1 and R2.

The etching operation in this step may pull back a portion of each of the 1^{st} sacrificial layers 211 and the 2^{nd} sacrificial layers 221 from the side surface thereof exposed through the recesses R1 and R2. For example, dry etching or wet etching may be applied using, for example, hydrofluoric acid (HF), which etches a Ge component or an SiGe component in these sacrificial layers 211 and 221 without attacking the channel layers 212 and 222 formed of silicon (Si) and the middle isolation structure 24 formed of silicon nitride or a composite thereof, not being limited thereto.

After the etching operation in this step, side recesses R3 may be formed on the side surfaces of the 1^{st} sacrificial layers 211 and side recesses R4 may be formed on the side surfaces of the 2^{nd} sacrificial layers 221, respectively.

Referring to FIG. 4D, inner spacers 216 may be formed in the side recesses R3 on the side surfaces of the 1^{st} sacrificial layers 211 in each of the semiconductor stacks 20A-20C, but not in the side recesses R4 on the side surfaces of the 2^{nd} sacrificial layers 221.

The formation of the inner spacers 216 in the side recesses R3 may be performed by depositing an inner spacer material such as silicon nitride, silicon oxide or a composite thereof (e.g., SiN, SiO₂, SiBCN, SiCN, SiON, SiOCN, etc.) through, for example, atomic layer deposition (ALD), physical vapor deposition (PVD), plasma enhanced atomic layer deposition (PEALD), chemical vapor deposition (CVD), plasma enhanced chemical vapor deposition (PECVD), or a combination thereof, not being limited thereto, in the side recesses R3, followed by dry etching so that side surfaces of the inner spacers 216 and 1^{st} channel layers 212 exposed to the recesses R1 and R2 may be vertically aligned or coplanar.

Here, the inner spacers 216 may not be formed in the side recesses R4 on the side surfaces of the 2^{nd} sacrificial layers 221 so that, as will be described later in reference to FIGS. 4E-4H, 2^{nd} source/drain patterns 245 to be formed from the 2^{nd} channel layers 222 cannot be affected by the inner spacers.

Referring to FIG. 4E, 1^{st} source/drain patterns 235 may be formed in the recesses R1 and R2 at sides of the 1^{st} channel structures 210.

The 1^{st} source/drain patterns 235 may be epitaxially grown from the 1^{st} channel layers 212 of the 1^{st} channel structure 210 while the 1^{st} sacrificial layers 211 are covered by the inner spacers 216 so that SiGe included in the 1^{st} sacrificial layers 211 do not interfere epitaxial growth of Si to form the 1^{st} source/drain patterns 235. At this time, n-type impurities such as phosphorus (P), arsenic (As), antimony (Sb), etc. may be in-situ doped in the epitaxial structure to form the 1^{st} source/drain patterns 235 as n-type.

Further, a 1^{st} isolation structure 241 may be formed on the 1^{st} source/drain patterns 235 to isolate the 1^{st} source/drain patterns 235 from other circuit elements. The 1^{st} isolation structure 241 may be formed by depositing a material such as silicon oxide (e.g., SiO or SiO₂) through, for example, PVD, CVD, PECVD, or a combination thereof, followed by planarization such as chemical-mechanical polishing (CMP), not being limited thereto. Prior to the formation of the 1^{st} isolation structure 241, a 1^{st} protection layer 236 of silicon nitride or a composite thereof (e.g., SiN, Si₃N₄, SiBCN, SiCN, SiOCN, etc.) may be formed on a top surface of each of the 1^{st} source/drain patterns 235 through, for example, ALD, not being limited thereto, at least to prevent oxidation thereof from the 1^{st} isolation structure 241. Further, a residue of a blocking layer 234 used to cover the 2^{nd} channel structure 220 when the 1^{st} source/drain patterns 235 are formed may remain at sides of the middle isolation structure 240, above the 1^{st} source/drain patterns 235. The blocking layer 234 may include a material such as a silicon nitride (e.g., SiN, Si₃N₄, etc.), not being limited thereto.

Referring to FIG. 4F, an hydrogen (H₂) baking process as preparation for epitaxial growth of SiGe from the 2^{nd} channel layers 222 may be applied to an intermediate semiconductor device 20' obtained in the previous step to form a contact layer 245C of SiGe along the side surfaces of the 1^{st} channel structures 210 exposed to the recesses R1 and R2.

The hydrogen baking process may be performed in a high-temperature furnace or in a rapid thermal processing (RTP) system under a hydrogen gas ambient to clean surfaces of the 2^{nd} channel layers 222 exposed to the recesses R1 and R2 for preparation of epitaxial growth therefrom. By this hydrogen baking process, at least native oxide (e.g., SiO₂) and impurities formed on the 2^{nd} channel layers 222 of Si may be evaporated through a chemical reaction to facilitate epitaxial growth of SiGe-containing source/drain patterns based on the 2^{nd} channel layers 222 of Si. At this time of the hydrogen baking process, SiGe forming the 2^{nd} sacrificial layers 221 stacked on the 2^{nd} channel layers 222 may be diffused on to the surfaces of the 2^{nd} channel layers 222 as well as the 2^{nd} sacrificial layers 221 exposed to the recesses R2 and R3 so that the contact layer 245C of SiGe can be formed on these surfaces.

The hydrogen baking process may be performed such that, at a temperature range of 800-1200°C, a hydrogen gas is applied to the 2^{nd} channel structure 210 exposed to the recesses R1 and R2 to form the contact layer 245C of SiGe having a Ge concentration of 20% or less, e.g., 15%.

Referring to FIG. 4G, the 2^{nd} source/drain patterns 245, each of which includes an inner portion 245A and an outer portion 245B, may be formed on the 2^{nd} channel structures 220 with the contact layer 245C therebetween in the recesses R1 and R2.

The epitaxy to form the 2^{nd} source/drain patterns 245 may be performed in a reaction chamber for vapor-phase epitaxy (VPE), molecular beam epitaxy (MBE), etc., not being limited thereto, such that a mixing ratio of an Si gas and a Ge gas are controlled to have different, discontinuous or discrete Ge concentrations by portion in each of the 2^{nd} source/drain patterns 245. For example, the 2^{nd} source/drain pattern 245 may be formed to have the outer portion 245B, having a Ge concentration lower than the contact layer 245C, and the inner portion 245A having a Ge concentration greater than the outer portion 245B as well as the contact layer 245C. For example, the inner portion 245A may have a Ge concentration of 40% to 50% and the outer portion 245B may have a Ge concentration of 10% or less, e.g., 5%. At this time, p-type impurities such as boron (B), gallium (Ga), indium (In), etc. may be in-situ doped in the epitaxial structure to form the 2^{nd} source/drain patterns 245 as p-type.

Here, the outer portion 245B and the inner portion 245A may be epitaxially grown from only the crystal structures of Si forming the 2^{nd} channel structures and SiGe of the contact layer 245C and the 2^{nd} sacrificial layers 221 because no inner spacers such as the inner spacers 216 are formed on the side surfaces of the 2^{nd} sacrificial layers 221. Thus, a crystal defect such as crack formation that may be caused by the inner spacers may not be generated in the 2^{nd} source/drain patterns 245 including the inner portion 245A and the outer portion 245B. Accordingly, the 2^{nd} source/drain patterns 245 of SiGe may be able to exert a sufficient compressive stress to the 2^{nd} channel layers 222 to enhance hole mobility therethrough between the 2^{nd} source/drain patterns 245, thereby enhancing device performance of the semiconductor device 20.

Referring to FIG. 4H, the dummy gate structure 215' and the sacrificial layers 211 and 221 may be removed from each of the semiconductor stacks 20A-20C and replaced by a gate structure 215 to form a target semiconductor device.

Prior to the removal of the dummy gate structure 215' and the sacrificial layers 211 and 221, a 2^{nd} isolation structure 242 may be formed on the 2^{nd} source/drain patterns 245 to isolate the 2^{nd} source/drain patterns 245 from other circuit elements including the 1^{st} source/drain patterns 235 in the same or similar method of forming the 1^{st} isolation structure 241 on the 1^{st} source/drain patterns 235 in the previous step (FIG. 4E). Further, prior to the formation of the 2^{nd} isolation structure 242, a 2^{nd} protection layer 246 may be formed on a top surface of each of the 2^{nd} source/drain patterns 245 at least to prevent oxidation thereof from 2^{nd} isolation structure 242 in the same or similar method of forming the 1^{st} protection layer 236 on the 1^{st} source/drain patterns 235 in the previous step (FIG. 4E). Moreover, the hard mask patterns 261 may be removed through, for example, ashing or stripping to expose

The removal of the dummy gate structures 215' and the sacrificial layers 211 and 221 may be performed through, for example, dry etching, wet etching, or a combination thereof, not being limited thereto, using, for example, hydrofluoric acid (HF), which may remove an SiGe layer with a high Ge concentration (e.g., 25-30%) against silicon (Si) and an SiGe layer with a low Ge concentration (e.g., 5-15%). Thus, when the sacrificial layers 211 and 221 having the Ge concentration of 25-30% are removed by the dry etching or wet etching, the channel layers 212 and 222 formed of Si without a Ge component, at least a portion of the contact layer 245C having the Ge concentration of 15% or less on the side surfaces of the 2^{nd} channel layers 212, and the outer portion 245B of the 2^{nd} source/drain patterns 245 may not be attacked by the etching operation. However, another portion of the contact layer 245C formed on the side surface of the 2^{nd} sacrificial layers 221 may be removed along with the 2^{nd} sacrificial layers 221 at least because of their proximity. Thus, while the contact layer 246C may be disposed between the outer portion 245B of the 2^{nd} source/drain pattern 245 and the 2^{nd} channel layer 222, the contact layer 246 may not be present between the outer portion 245B and a gate dielectric layer 215D of a gate structure 215 to replace the 2^{nd} sacrificial layer 221 in a next step. In the foregoing manner, the channel layers 212 and 222 may be released to an open space where the gate structure 215 is to be formed in the semiconductor stacks 20A-20C.

Subsequently, the gate dielectric layer 215D may be formed in the space provided by the removal of the dummy gate structure 215' and the sacrificial layers 211 and 221, and a gate metal structure 215M may be formed on the gate dielectric layer 215D. As described earlier, the gate dielectric layer 215D, like the gate dielectric layer 115D of FIG. 1, may include an interfacial layer formed of an oxide material such as silicon oxide (SiO), silicon dioxide (SiO₂), and/or silicon oxynitride (SiON), and a high-k layer formed of a high-k material such as Hf, Al, Zr, La, Mg, Ba, Ti, Pb, and/or a combination thereof, not being limited thereto. Further, the gate metal structure 215M may include a work-function metal layer and a gate electrode. The work-function metal layer of the gate metal structure 215M may be formed of a metal such as Cu, Al, Ti, Ta, W, Co, TiN, WN, TiAl, TiAIN, TaN, TiC, TaC, TiAlC, TaCN, TaSiN, and/or a combination thereof, not being limited thereto. The gate electrode of the gate metal structure 215M may be formed of Cu, W, Al, Ru, Mo, Co, and/or a combination thereof, not being limited thereof. Thus, the gate dielectric layer 215D may function as an isolation layer between the 2^{nd} source/drain patterns 245 and the gate metal structure 215M. The formation of the gate structure 215 may be performed through, for example, PVD, CVD, PECVD, ALD, PEALD, or a combination thereof, not being limited thereto.

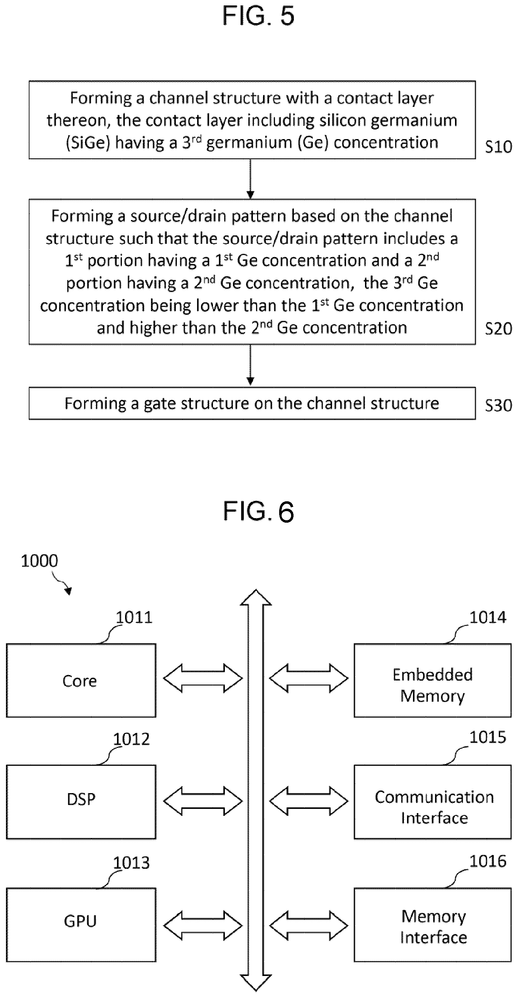

FIG. 5 is a flowchart of manufacturing a semiconductor device shown in FIGS. 2A-2C in reference to FIGS. 4A-4H, according to one or more embodiments.

In step S10, a channel structure with a contact layer including a silicon germanium (SiGe) with a 3^{rd} Ge concentration may be formed on a substrate (FIGS. 4A-4F).

The channel structure may include a plurality of sacrificial layers formed of SiGe and channel layers formed of Si which are alternately stacked on the substrate. The contact layer may be formed on a surface of the channel layers by a hydrogen baking process which cleans the surface of the channel layers from which a source/drain region is to be epitaxially grown. In the hydrogen baking process, SiGe forming the sacrificial layers may be diffused such that the contact layer of SiGe is formed along the surfaces of the channel layers as well as the sacrificial layers to have a 3^{rd} Ge concentration, for example, 15%.

In step S20, a source/drain pattern may be formed from the channel structure such that the source/drain pattern includes a 1^{st} portion (inner portion) having a 1^{st} Ge concentration, for example, 40%, and a 2^{nd} portion (outer portion) having a 2^{nd} Ge concentration, for example, 5%. Here, the 3^{rd} Ge concentration of the contact layer may be lower than the 1^{st} Ge concentration and higher than the 2^{nd} Ge concentration.

The formation of the source/drain pattern may be performed though vapor-phase epitaxy (VPE), molecular beam epitaxy (MBE), etc. based on the channel structure including the sacrificial layers and the channel layers with the contact layer thereon. Here, an inner spacer structure may not be formed on side surfaces of the sacrificial layers, and thus, the formation of the source/drain pattern may not be affected by the inner spacers, thereby preventing formation of a crystal defect in the source/drain pattern. Further, epitaxial growth of the source/drain pattern may be controlled such that the 2^{nd} portion contacting the channel structure may have the 2^{nd} Ge concentration of, for example, 5%, and the 1^{st} portion on the 2^{nd} portion may have the 1^{st} Ge concentration of, for example, 40%.

In step S30, the sacrificial layers of the channel structure may be removed and a gate structure may be formed in a space provided by the removal of the sacrificial layers.

The gate structure may be formed such that the sacrificial layers are removed through, for example, wet etching against the channel layers of Si, and forming a gate dielectric layer and a gate metal structure on the gate dielectric layer in the space provided by the removal of the sacrificial layers. Thus, the gate dielectric layer may isolate the gate metal structure from the source/drain pattern.

Thus, a semiconductor device, in which a source/drain pattern has a multiple layer structure having different Ge concentrations by portion, and no inner spacers are formed, may be manufactured.

FIG. 6 is a schematic block diagram illustrating an electronic device including at least one of the semiconductor devices shown in FIGS. 2A-2C and FIGS. 3A-3C, according to one or more embodiments.

Referring to FIG. 5, an SoC 1000 may be an integrated circuit in which components of a computing system or other electronic systems are integrated. As an example of the SoC 1000, an application processor (AP) may include at least one processor and components for various functions. The SoC 1000 may include a core 1011 (e.g., a processor), a digital signal processor (DSP) 1012, a graphic processing unit (GPU) 1013, an embedded memory 1014, a communication interface 1015, and a memory interface 1016. The components of the SoC 1000 may communicate with each other through a bus 1007.

The core 1011 may process instructions and control operations of the components included in the SoC 1000. For example, the core 1011 may process a series of instructions to run an operating system and execute applications on the operating system. The DSP 1012 may generate useful data by processing digital signals (e.g., a digital signal provided from the communication interface 1015). The GPU 1013 may generate data for an image output by a display device from image data provided from the embedded memory 1014 or the memory interface 1016, or may encode the image data.

The embedded memory 1014 may store data necessary for the core 1011, the DSP 1012, and the GPU 1013 to operate. The communication interface 1015 may provide an interface for a communication network or one-to-one communication. The memory interface 1016 may provide an interface for an external memory of the SoC 1000, such as a dynamic random access memory (RAM) (DRAM), a flash memory, etc.

At least one of the core 1011, the DSP 1012, the GPU 1013, and/or the embedded memory 1014 may include at least one of the semiconductor devices shown in FIGS. 2A-2C and 3A-3C, respectively.

The foregoing is illustrative of example embodiments and is not to be construed as limiting the disclosure. Although a few example embodiments have been described, those skilled in the art will readily appreciate that many modifications are possible in the above embodiments without materially departing from the disclosure.

## Claims

1. A semiconductor device comprising:
a channel structure;
a source/drain pattern on the channel structure;
a gate structure on the channel structure; and
a contact layer on the channel structure,
wherein the contact layer contacts the source/drain pattern and comprises silicon germanium, SiGe.

2. The semiconductor device of claim 1, wherein the source/drain pattern comprises a 1^{st} portion and a 2^{nd} portion, the 2^{nd} portion being disposed between the 1^{st} portion and the contact layer, and
wherein the 1^{st} portion and the 2^{nd} portion have different germanium, Ge, concentrations.

3. The semiconductor device of claim 2, wherein a Ge concentration in the contact layer is higher than a Ge concentration in the 1^{st} portion and lower than a Ge concentration in the 1^{st} portion.

4. The semiconductor device of any one of claims 1 to 3, wherein an inner spacer comprising nitride is not disposed between the source/drain pattern and the gate structure.

5. The semiconductor device of claim 4, wherein the gate structure comprises a gate dielectric layer contacting the source/drain pattern.

6. The semiconductor device of any one of claims 1 to 5, wherein the source/drain pattern is of n-type and comprises silicon, Si.

7. The semiconductor device of any one of claims 1 to 6, further comprising:
another channel structure above or below the channel structure in a vertical direction;
another source/drain pattern on the other channel structure;
another gate structure on the other channel structure; and
an inner spacer between the other source/drain pattern and the other gate structure.

8. The semiconductor device of claim 7, wherein the gate structure and the other gate structure are connected to form a common or shared gate structure.

9. The semiconductor device of any one of claims 1 to 6, further comprising:
another channel structure above or below the channel structure in a vertical direction;
another source/drain pattern on the other channel structure;
another gate structure on the other channel structure; and
another contact layer between the other source/drain pattern and the other channel structure,
wherein the other contact layer contacts the other source/drain pattern and comprises SiGe.

10. The semiconductor device of claim 9, wherein the source/drain pattern is of p-type and the other source/drain pattern is of n-type.

11. The semiconductor device of claim 9 or 10, wherein the gate structure and the other gate structure are connected to form a common or shared gate structure.

12. A semiconductor device comprising:
a channel structure;
a source/drain pattern on the channel structure; and
a gate structure on the channel structure,
wherein an inner spacer comprising nitride is not disposed between the source/drain pattern and the gate structure.

13. The semiconductor device of claim 12, wherein the gate structure comprises a gate dielectric layer contacting the source/drain pattern.
